# EUROPÄISCHE PATENTSCHRIFT

(11) **EP 2 294 622 B1**
(45) Veröffentlichungstag und Bekanntmachung des Hinweises auf die Patenterteilung: **24.01.2018**
(21) Anmeldenummer: 09757225.9
(22) Anmeldetag: 28.05.2009
(51) Int. Cl.: H01L 31/052, H01L 31/18, F24J 2/46

(54) **TROCKNUNGSVORRICHTUNG UND TROCKNUNGSVERFAHREN FÜR SOLARMODULE**
DRYING DEVICE AND DRYING METHOD FOR SOLAR MODULES
DISPOSITIF ET PROCÉDÉ DE SÉCHAGE POUR MODULES SOLAIRES

(30) Priorität: 30.05.2008 DE 102008025958
(43) Veröffentlichungstag der Anmeldung: 16.03.2011
(73) Patentinhaber: Saint-Augustin Canada Electric Inc., Saint-Augustin de Desmaures, Québec G3A 1S5 (CA)
(72) Erfinder: VOGT, Achim, 79102 Freiburg (DE); HAARBURGER, Karl, Friedrich, 79249 Merzhausen (DE); HAKENJOS, Alexander, 79400 Kandern (DE); NUNEZ, Tomas, 79106 Freiburg (DE); MORGENSTERN, Alexander, 79111 Freiburg (DE)
(74) Vertreter: Grünecker Patent- und Rechtsanwälte PartG mbB
(86) Internationale Anmeldenummer: PCT/EP2009/003829
(87) Internationale Veröffentlichungsnummer: WO 2009/146842

(56) Entgegenhaltungen:
- EP-A- 0 788 171
- WO-A-2007/087343
- US-A- 4 341 539
- US-A- 5 022 930
- US-A1- 2003 218 751
- US-A1- 2007 251 569
- US-B1- 6 201 179
- US-B2- 7 145 629

## Beschreibung

Die Erfindung betrifft eine Vorrichtung und ein Verfahren zum Trocknen des Inneren von Solarmodulen. Die Vorrichtung und das Verfahren sind besonders für Konzentrator-Photovoltaik (CPV) -Module geeignet.

In Konzentrator-Photovoltaik-Modulen wird normalerweise von der Sonne eingestrahltes Licht durch Linsen auf Solarzellen mit relativ kleiner Fläche gebündelt. Hierbei sind die Solarzellen auf der Bodenplatte eines Moduls angeordnet und verschaltet, während die Linsen auf einer Linsenplatte angeordnet sind, die sich parallel zur Bodenplatte erstreckt. Jeder Solarzelle ist eine Linse zugeordnet, welche auf sie einfallendes Licht auf die entsprechende Solarzelle konzentriert. Entscheidend ist hierbei, dass der Abstand zwischen Linsen- und Bodenplatte möglichst genau eingehalten wird, da durch eine Defokussierung der Wirkungsgrad des Solarzellenmoduls herabgesetzt würde.

In der US 2007/0251569 wird ein Solarmodul beschrieben, dem in einem Betriebsmodus trockene Luft zugeführt wird, und wobei in einem anderen Betriebsmodus eine Wasserfalle des Solarmoduls, über die die getrocknete Luft in dem einen Betriebsmodus zugeführt wird, durch Aufheizen regeneriert wird.

Grundsätzlich wäre es wünschenswert, Solarmodule möglichst luftdicht verschlossen zu halten, um eine Schädigung der Solarzellen und elektrischen Bauteile im Modul durch Umwelteinflüsse zu verhindern. Es ist jedoch so, dass das Solarzellenmodul bei Sonnenbestrahlung eine sehr viel höhere Temperatur hat als dies ohne Sonneneinstrahlung der Fall wäre. Dies führt dazu, dass der Innendruck des Solarmoduls mit der temperaturabhängigen Ausdehnung der in ihm enthaltenen Luft stark variiert, was bei einem abgeschlossenen Modul zu einer Wölbung der Linsenplatte führen würde. Eine solche Wölbung würde die Fokussierung und damit den Wirkungsgrad des Moduls beeinträchtigen. Um eine solche Beeinträchtigung zu vermeiden, wird ein Gasaustausch zwischen dem Inneren des Moduls und der Umgebung zugelassen, so dass bei Expansion des Gases durch Temperaturerhöhung dieses aus dem Modul entweichen kann. Andererseits kann bei Abkühlung Gas in das Modul hineinströmen.

Es ergibt sich hierbei das Problem, dass die im Solarmodul angeordneten Solarzellen und elektrischen Bauteile durch mit einströmender Luft eingebrachte Luftfeuchtigkeit und Schadstoffe auf Dauer geschädigt werden.

Aufgabe der vorliegenden Erfindung ist es daher, eine Vorrichtung und ein Verfahren anzugeben, mit welchen Schadstoffe und Feuchtigkeit aus einem Solarmoduls entfernt und das Solarmodul getrocknet werden können.

Diese Aufgabe wird gelöst durch die Vorrichtung nach Anspruch 1 und das Verfahren nach Anspruch 9. Vorteilhafte Weiterbildungen der erfindungsgemäßen Vorrichtung und des erfindungsgemäßen Verfahrens werden durch die jeweiligen abhängigen Ansprüche gegeben. Anspruch 8 beschreibt ein mit der erfindungsgemäßen Vorrichtung ausgestattetes Solarmodul.

Die Erfindung basiert auf der Idee, das Solarmodul regelmäßig, beispielsweise jeweils nach Sonnenuntergang, mit getrockneter und/oder gefilterter Luft zu spülen. Durch die Spülung mit trockener Luft wird das Niveau der relativen Luftfeuchtigkeit im Modul niedrig gehalten. Hierdurch wird die Lebenszeit der im Modul angeordneten elektrischen Bauteile, wie beispielsweise Solarzellen, Dioden und Verbindungsdräh-ten, deutlich verlängert, so dass sich auch die Nutzungsdauer des Solarmoduls deutlich verlängert. Hierdurch sinken die Kosten pro erzeugter Energieeinheit und die Garantiedauern können verlängert werden.

Erfindungsgemäß kann eine solche Spülung eines Solarmoduls mit trockener Luft durch die erfindungsgemäße Trocknungsvorrichtung bewirkt werden. Diese erfindungsgemäße Trocknungsvorrichtung weist einen Adsorber auf, mit welchem Gas, vorzugsweise Luft, welches diesen Adsorber durchströmt, trockenbar ist. Zum Spülen eines Moduls mit getrockneter Luft wird also Luft durch den Adsorber hindurch in das Modul geleitet. Das Modul ist an die erfindungsgemäße Trocknungsvorrichtung über einen Anschluss angekoppelt.

Um eine dauerhafte Funktionstüchtigkeit der Trocknungsvorrichtung zu gewährleisten, ist es notwendig, dass der Adsorber regelmäßig regeneriert und/oder getrocknet wird. Erfindungsgemäß weist daher die Trocknungsvorrichtung ein Heizelement auf, mit welchem Gas, das das Heizelement durchströmt, erwärmbar ist.

Derart erwärmtes Gas wie z.B. Luft wird anschließend durch den Adsorber geleitet, der hierdurch regeneriert bzw. getrocknet wird. Um die erwärmte Luft zum Regenerieren des Adsorbers nicht in das Solarmodul leiten zu müssen, weist die Trocknungsvorrichtung eine Abzweigung mit einer Auslassöffnung auf, die zwischen dem Adsorber und dem Anschluss zum Anschließen eines Solarmoduls abzweigt und nach außen mündet. In einer solchen Abzweigung ist dann vorzugsweise ein Ventil angeordnet, welches geöffnet wird, wenn der Adsorber zur Regeneration von erwärmter Luft durchströmt wird, und welches geschlossen wird, wenn der Adsorber von nicht erwärmter Luft durchströmt wird, mit welcher das Solarmodul gespült werden soll. Vorzugsweise ist zwischen der Abzweigung und dem Anschluss für ein Solarmodul ein weiteres Ventil angeordnet, welches geschlossen wird, wenn erwärmte Luft zur Regeneration durch den Adsorber strömt und welches geöffnet wird, wenn kalte, vom Adsorber getrocknete Luft in das Solarmodul geleitet werden soll. Hinter der Auslassöffnung kann ein weiterer Filter angeordnet sein.

Das Heizelement kann erfindungsgemäß unter anderem ein Solarthermischer Kollektor, eine Vakuumkollektorröhre und/oder eine elektrische Heizung sein. Darüber hinaus ist es außerdem auch möglich, direkt am oder im Adsorber zumindest eine weitere Heizvorrichtung anzuordnen, welche beim Regenerieren den Adsorber selbst erwärmt. Auch hier kann die Heizung durch Sonnenenergie oder durch elektrische Energie erfolgen.

Besonders bevorzugt ist es, wenn die Trocknungsvorrichtung eine Bypass-Leitung aufweist, mit welcher durch einen Gaseinlass in die Trocknungsvorrichtung einströmende Luft am Heizelement vorbei in den Adsorber geleitet werden kann. Dies ist besonders dann sinnvoll, wenn das Heizelement mit Sonnenenergie arbeitet oder nicht ohne weiteres abkühlbar ist.

Vorzugsweise ist in der Bypass-Leitung ein Ventil angeordnet, mit welchem der Luftstrom durch die Bypass-Leitung regelbar ist. Darüber hinaus kann ein Ventil zwischen der Abzweigung der Bypass-Leitung und der Einlassöffnung des Heizelementes angeordnet sein, mit welcher der Gasfluss in das Heizelement regelbar ist.

Die erfindungsgemäße Trocknungsvorrichtung ist also in zwei Modi betreibbar. Zum einen im Trocknungsmodus, in welchem ein Solarmodul mit getrockneter Luft gespült wird, zum anderen im Regenerationsmodus, in welchem der Adsorber regeneriert und/oder getrocknet wird.

Im Trocknungsmodus wird das Gas, also vorzugsweise die Luft, welches durch eine Einlassöffnung in die Trocknungsvorrichtung hinein strömt bzw. hineingepumpt wird, zunächst durch einen optionalen Filter, beispielsweise einen Staubfilter, geleitet. Anschließend durchströmt die Luft das nicht geheizte Heizelement oder den das Heizelement umlaufenden Bypass, um dann durch eine Einlassöffnung in den Adsorber zu strömen. Ist in der Trocknungsvorrichtung eine solche Bypass-Leitung vorgesehen, so wird vorzugsweise im Trocknungsmodus das mögliche Ventil vor dem Eingang des Heizelementes geschlossen und das Ventil in der Bypass-Leitung geöffnet.

Nach dem Durchströmen des Adsorbers strömt die Luft durch eine Auslassöffnung aus dem Adsorber hinaus und durch das geöffnete optionale zweite Ventil und den Anschluss in das zu trocknende Solarmodul.

Im Regenerationsmodus wird wiederum Luft durch eine Einlassöffnung und einen optionalen Filter in die Vorrichtung hinein gepumpt, wobei sie zunächst das Heizelement durchströmt, um anschließend den Adsorber zu durchströmen. Ist hier eine Bypass-Leitung vorgesehen, so ist das vorzugsweise in der Bypass-Leitung angeordnete Ventil geschlossen, während das vorzugsweise vor dem Eingang des Heizelementes angeordnete Ventil geöffnet ist. Bevorzugt ist nun zwischen dem Ausgang des Adsorbers und dem Anschluss für ein Solarmodul über eine Abzweigung und ein Ventil eine Auslassöffnung vorgesehen. Im Regenerationsmodus ist dieses Ventil geöffnet, so dass durch den Adsorber strömende warme Luft durch das Ventil hindurch aus der Auslassöffnung heraus strömen kann. Ein zwischen der Abzweigung und dem Anschluss für das Solarmodul angeordnetes Ventil wäre hierbei geschlossen, um ein Einströmen der erwärmten Luft in das Solarmodul zu verhindern.

Trocknungs- und Regenerationsmodus werden vorzugsweise abwechselnd, beispielsweise im Tag-Nacht-Zyklus durchlaufen.

Zur Gewährleistung der Strömung weist die Trocknungsvorrichtung vorzugsweise ein Gebläse oder einen Ventilator auf. Diese kann unmittelbar hinter der Einlassöffnung oder unmittelbar hinter einem Filter hinter der Einlassöffnung angeordnet sein.

Als Sorbens im Adsorber ist Silikagel besonders geeignet. Das Gas zur Trocknung und zur Regeneration ist vorzugsweise Luft.

Erfindungsgemäß ist auch ein Verfahren zur Trocknung eines Solarmoduls, wie es mit der erfindungsgemäßen Trocknungsvorrichtung durchgeführt werden kann. In diesem Verfahren wird in einem Schritt Gas, vorzugsweise Luft, bei einer ersten Temperatur durch zumindest einen Adsorber in ein Solarmodul geleitet. In diesem Schritt ist das Solarmodul mit durch den Adsorber getrockneter Luft spülbar. Dieser Schritt entspricht also dem Trocknungsmodus.

In einem anderen Schritt, dem Regenerationsschritt, wird Gas, vorzugsweise Luft, zunächst in einem Heizelement auf eine zweite Temperatur erwärmt, die höher als die oben genannte erste Temperatur ist. Anschließend wird die erwärmte Luft durch den Adsorber geleitet, so dass dieser getrocknet und/oder regeneriert wird. Dieser Schritt entspricht dem Regenerationsmodus.

Vorzugsweise werden die beiden oben beschriebenen Schritte der Spülung mit trockener Luft und der Regenerierung des Adsorbers abwechselnd durchgeführt, so dass, nachdem Luft durch den Adsorber getrocknet wurde, dieser regeneriert wird. Er steht dann wieder zur Trocknung weiterer Luft zur Verfügung.

Wie auch in der oben beschriebenen Vorrichtung kann im erfindungsgemäßen Verfahren die Erwärmung der Luft u.a. durch solarthermische Kollektoren, Vakuumkollektorröhren und/oder elektrische Heizungen erfolgen. Auch ist es möglich, im Regenerationsschritt den Adsorber selbst direkt zu erwärmen. Um die Lebensdauer der eingesetzten Komponenten zu erhöhen, ist es bevorzugt, wenn die Luft vor dem Einströmen in das Heizelement bzw. den Adsorber durch einen Filter, beispielsweise einen Staubfilter, gefiltert wird.

Im Folgenden soll die erfindungsgemäße Vorrichtung und das erfindungsgemäße Verfahren anhand von Figuren beispielhaft erläutert werden.

Es zeigt
- Figur 1: eine erfindungsgemäße Trocknungsvorrichtung während des Spülens eines Solarmoduls mit getrockneter Luft und
- Figur 2: eine erfindungsgemäße Trocknungsvorrichtung während des Regenerierens des Adsorbers.

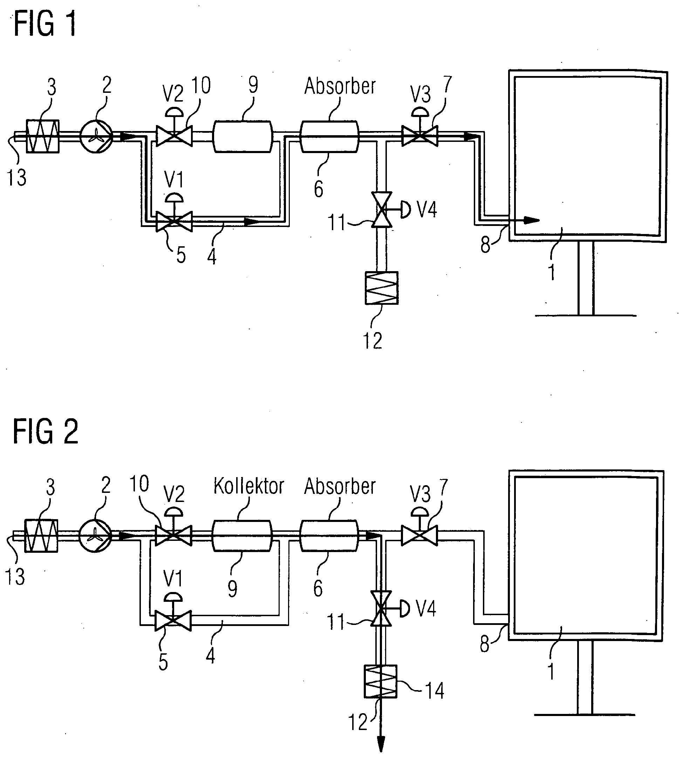

Figur 1 zeigt eine erfindungsgemäße Trocknungsvorrichtung zur Trocknung eines Solarmoduls 1. Das Solarmodul kann beispielsweise ein Flatcon-Konzentratormodul der Firma Concentrix Solar GmbH sein. Hierbei wird durch eine Pumpe 2, ein Gebläse 2 oder ein Ventilator 2 Luft durch einen Staubfilter 3 in die Vorrichtung gepumpt. Das Gebläse 2 ist hierbei in Strömungsrichtung der Luft unmittelbar hinter dem Staubfilter 3 angeordnet. Die erfindungsgemäße Trocknungsvorrichtung ist in Figur 1 in jenem Zustand gezeigt, in welchem das Solarmodul 1 mit getrockneter Luft gespült wird. Hierbei wird die Luft hinter dem Gebläse 2 durch ein in einer Bypass-Leitung 4 angeordnetes Ventil 5 durch die Bypass-Leitung 4 in einen Adsorber 6 geleitet. Nach dem Durchströmen des Adsorbers 6 fließt die Luft durch ein Ventil 7 und den Anschluss 8 in das Solarmodul 1. Ein Durchströmen des Heizelementes 9 wird durch Schließen des vor dem Eingang des Heizelementes angeordneten Ventils 10 verhindert. Das während des Spülens mit trockener Luft geschlossene Ventil 11 verhindert außerdem ein Entweichen der Luft, welche den Adsorber 6 durchströmt hat durch den Auslass 12. Während des Spülens mit trockener Luft durchströmt die Luft in der erfindungsgemäßen Trocknungsvorrichtung zunächst die Einlassöffnung 13, anschließend den Staubfilter 3, daraufhin das Gebläse 2. Anschließend strömt die Luft durch das in der Bypass-Leitung 4 angeordnete Ventil 5 und durch die Bypass-Leitung 4. Die Luft strömt dann durch den Adsorber 6 und das Ventil 7 durch die Auslassöffnung 8 in das Solarmodul 1.

Figur 2 zeigt nun die erfindungsgemäße Vorrichtung während der Regeneration des Adsorbers. Gleiche Bezugszeichen entsprechen hier den gleichen Elementen wie in Figur 1. Während der Regeneration wird die Luft durch die Einlassöffnung 13 von dem Gebläse 2 in die Vorrichtung gepumpt. Hierbei durchströmt sie zunächst den Filter 3, anschließend das Gebläse 2 und daraufhin das nun geöffnete Ventil 10. Das in der Bypass-Leitung 4 angeordnete Ventil 5 ist nun geschlossen. Hinter dem Ventil 10 durchströmt nun die Luft das Heizelement 9, wo sie erwärmt wird. Die erwärmte Luft strömt dann durch den Adsorber 6, der hierbei regeneriert und/oder getrocknet wird. Nach dem Durchlaufen des Adsorbers 6 läuft die Luft durch das nun geöffnete Ventil 12 und einen weiteren Staubfilter 14 durch den Auslass 12 nach außen. Das vor dem Anschluss 8 angeordnete Ventil 7 ist geschlossen und verhindert, dass die erwärmte Luft in das Solarmodul 11 strömt.

Durch Öffnen und Schließen der Ventile 5, 7, 10 und 11 kann die erfindungsgemäße Trocknungsvorrichtung also zwischen dem Zustand des Spülens des Solarmoduls mit trockener Luft und dem Zustand des Regenerierens des Adsorbers umgeschaltet werden.

## Patentansprüche

1. Trocknungsvorrichtung für Solarmodule (1) mit zumindest einem Adsorber (6), mit welchem den Adsorber (6) durchströmendes Gas trockenbar ist, wobei der Adsorber einen Eingang und einen Ausgang für das ihn durchströmende Gas aufweist, zumindest einem Heizelement (9), mit welchem das Heizelement (9) durchströmendes Gas erwärmbar ist, wobei das Heizelement einen Eingang und einen Ausgang für das durchströmende Gas aufweist, sowie einem Anschluss (8), über den Gas in ein Solarmodul (1) leitbar ist, wobei der Ausgang des Adsorbers (6) mit dem Anschluss (8) gasleitend verbunden ist;
**gekennzeichnet dadurch, dass**
der Ausgang des Heizelementes (9) mit dem Eingang des Adsorbers (6) gasleitend verbunden ist und die Trocknungsvorrichtung eine Auslassöffnung (12), die über ein erstes Ventil (11) mit dem Ausgang des Adsorbers (6) über eine Abzweigung zwischen diesem Ausgang und dem Anschluss (8) gasleitend verbunden ist, umfasst.

2. Trocknungsvorrichtung nach dem vorhergehenden Anspruch, umfassend eine Bypass - Leitung (4), mit welcher Gas am Heizelement (9) vorbei in den Eingang des Adsorbers (6) leitbar ist, ein zweites Ventil (7) zwischen der Abzweigung und dem Anschluss (8), mit welchem der Gasfluss aus dem Anschluss (8) regelbar ist und/oder ein drittes Ventil (5), das in der Bypass - Leitung (4) angeordnet ist und mit welchem der Gasfluss durch die Bypass -Leitung (4) regelbar ist, und/oder ein viertes Ventil (10), welches unmittelbar vor dem Eingang des Heizelementes (9) angeordnet ist und mit welchem der Gasfluss in das Heizelement (9) regelbar ist.

3. Trocknungsvorrichtung nach einem der vorhergehenden Ansprüche, umfassend eine Pumpe (2), ein Gebläse (2) und/oder einen Ventilator (2), mit welchem Gas in die Trocknungsvorrichtung und/oder in den Eingang des Heizelementes (9) und/oder in den Eingang des Adsorbers (6) und/oder in die Bypass -Leitung (4) pumpbar oder bewegbar ist.

4. Trocknungsvorrichtung nach einem der vorhergehenden Ansprüche, umfassend einen Staubfilter (3), der in Richtung des Gasflusses vor der Pumpe (2) und/oder dem Gebläse (2) und/oder dem Ventilator (2) und/oder vor dem Heizelement (9) und/oder vor dem Adsorber (6) angeordnet ist und/oder durch einen Staubfilter (14) an der Auslassöffnung (12).

5. Trocknungsvorrichtung nach einem der vorhergehenden Ansprüche, wobei das Heizelement (9) ein solarthermischer Kollektor und/oder eine Vakuumkollektorröhre und/oder eine elektrische Heizung ist.

6. Trocknungsvorrichtung nach einem der vorhergehenden Ansprüche, wobei der Adsorber (6) mittels einer am Adsorber angeordneten Heizung und/oder durch Sonneneinstrahlung auf das Element erwärmbar ist.

7. Trocknungsvorrichtung nach einem der vorhergehenden Ansprüche , wobei der Adsorber (6) Silikagel enthält.

8. Solarmodul, umfassend eine Trocknungsvorrichtung nach einem der vorhergehenden Ansprüche.

9. Verfahren zur Trocknung eines Solarmoduls (1), wobei in einem Schritt Gas bei einer ersten Temperatur durch zumindest einen Adsorber (6) über einen Anschluss (8) in das Solarmodul (1) geleitet wird und wobei Gas, insbesondere Luft, in einem anderen Schritt zunächst auf eine zweite Temperatur, welche höher als die erste Temperatur ist, erwärmt wird und danach durch den Adsorber (6) geleitet wird, um diesen zu trocknen und/oder zu regenerieren;
**dadurch gekennzeichnet dass**
das Gas in dem anderen Schritt in einem Heizelement (9) auf die zweite Temperatur erwärmt wird, das von dem Adsorber (6) verschieden ist und von dem Adsorber (6) über eine Auslassöffnung (12), die über ein erstes Ventil (11) mit dem Ausgang des Adsorbers (6) über eine Abzweigung zwischen diesem Ausgang und dem Anschluss (8) gasleitend verbunden ist, ausgeleitet wird.

10. Verfahren nach dem vorhergehenden Anspruch, wobei das Heizelement ein solarthermischer Kollektor und/oder eine Vakuumkollektorröhre und/oder eine elektrische Heizung ist.

11. Verfahren nach einem der beiden vorhergehenden Ansprüche, wobei der Adsorber im anderen Schritt, insbesondere mittels einer am Adsorber angeordneten elektrischen Heizung und/oder durch Einstrahlung von Sonnenstrahlung auf den Adsorber, erwärmt wird.

12. Verfahren nach einem der Ansprüche 9 bis 11, wobei Gas im einen und/oder im anderen Schritt vor und/oder nach dem Durchlaufen des Adsorbers und/oder des Heizelementes durch Staubfilter geleitet wird.

13. Verfahren nach einem der Ansprüche 9 bis 11, wobei das Verfahren mit einer Trocknungsvorrichtung nach einem der Ansprüche 1 bis 7 durchgeführt wird.

## Claims

1. A drying apparatus for solar modules (1), comprising at least one absorber (6) by means of which gas flowing through the absorber (6) can be dried, said absorber having an inlet and an outlet for the gas flowing therethrough, at least one heating element (9) by means of which gas flowing through said heating element (9) can be heated, said heating element having an inlet and an outlet for the gas flowing therethrough, and a connection (8) through which gas can be conducted into a solar module (1), wherein the outlet of the absorber (6) communicates with the connection (8) in a gas-conducting manner, and
**characterized in that** the outlet of the heating element (9) communicates with the inlet of the absorber (6) in a gas-conducting manner and the drying apparatus comprises an outlet opening (12) which is connected in a gas-conducting manner via a first valve (11) to the outlet of the absorber (6) via a branch located between this outlet and the connection (8).

2. A drying apparatus according to the preceding claim, comprising a bypass conduit (4) by means of which gas can be conducted past the heating element (9) into the inlet of the absorber (6), a second valve (7) disposed between the said branch and the connection (8) and adapted to be used for controlling the flow of gas from the connection (8) and/or a third valve (5) disposed in the bypass conduit (4) and adapted to be used for controlling the flow of gas through the bypass conduit (4) and/or a fourth valve (10) disposed directly upstream of the inlet of the heating element (9) and adapted to be used for controlling the flow of gas into the heating element (9).

3. A drying apparatus according to one of the preceding claims, comprising a pump (2), a blower (2) and/or a fan (2) by means of which gas can be pumped or moved into the drying apparatus and/or into the inlet of the heating element (9) and/or into the inlet of the absorber (6) and/or into the bypass conduit (4).

4. A drying apparatus according to one of the preceding claims, comprising a dust filter (3) arranged, in the direction of gas flow, upstream of the pump (2) and/or the blower (2) and/or the fan (2) and/or upstream of the heating element (9) and/or upstream of the absorber (6), and/or by a dust filter (14) at the outlet opening (12).

5. A drying apparatus according to one of the preceding claims, wherein the heating element (9) is a solar thermal collector and/or a vacuum collector tube and/or an electric heating.

6. A drying apparatus according to one of the preceding claims, wherein the absorber (6) can be heated by means of a heating arranged on the absorber and/or by solar radiation incident on the element.

7. A drying apparatus according to one of the preceding claims, wherein the absorber (6) contains silica gel.

8. A solar module, comprising a drying apparatus according to one of the preceding claims.

9. A method of drying a solar module (1), wherein, in one step, gas having a first temperature is conducted through at least one absorber (6) via a connection (8) into the solar module (1), and wherein, in another step, gas, in particular, air, is first heated to a second temperature, which is higher than the first temperature, and is then conducted through the absorber (6) so as to dry and/or regenerate the same;
**characterized in that**
the gas is heated to the second temperature in the other step in a heating element (9) that is different from the absorber (6) and is conducted from the absorber (6) through an outlet opening (12) which is connected in a gas-conducting manner via a first valve (11) to the outlet of the absorber (6) via a branch located between this outlet and the connection (8).

10. A method according to the preceding claim, wherein the heating element is a solar thermal collector and/or a vacuum collector tube and/or an electric heating.

11. A method according to one of the two preceding claims, wherein the absorber is heated in said other step by means of an electric heating arranged on the absorber and/or by solar radiation incident on the absorber.

12. A method according to one of the claims 9 to 11, wherein, in said one and/or in said other step, gas is conducted through dust filters prior to and/or subsequent to flowing through the absorber and/or the heating element.

13. A method according to one of the claims 9 to 11, wherein the method is executed making use of a drying apparatus according to one of the claims 1 to 7.

## Revendications

1. Dispositif de séchage pour modules solaires (1), comprenant
au moins un adsorbeur (6) à l'aide duquel il est possible de sécher du gaz s'écoulant à travers l'adsorbeur (6), l'adsorbeur présentant une entrée et une sortie pour le gaz s'écoulant à travers,
au moins un élément chauffant (9) à l'aide duquel il est possible d"échauffer du gaz s'écoulant à travers l'élément chauffant (9), l'élément chauffant présentant une entrée et une sortie pour le gaz s'écoulant à travers,
ainsi qu'un raccord de branchement (8) par l'intermédiaire duquel du gaz peut être envoyé dans un module solaire (1), la sortie de l'adsorbeur (6) étant reliée, sur le plan de l'écoulement des gaz, au raccord de branchement (8),
**caractérisé en ce que**
la sortie de l'élément chauffant (9) est reliée, sur le plan de l'écoulement des gaz, à l'entrée de l'adsorbeur (6), et le dispositif de séchage comprend une ouverture d'évacuation (12), qui est reliée, sur le plan de l'écoulement des gaz, par l'intermédiaire d'une première vanne (11), à la sortie de l'adsorbeur (6), au moyen d'un piquage de dérivation entre cette sortie et le raccord de branchement (8).

2. Dispositif de séchage selon la revendication précédente, comprenant une conduite en dérivation (4), à l'aide de laquelle du gaz peut être envoyé dans l'entrée de l'adsorbeur (6) en contournant l'élément chauffant (9), une deuxième vanne (7) entre le piquage de dérivation et le raccord de branchement (8), à l'aide de laquelle il est possible de réguler le flux de gaz sortant du raccord de branchement (8), et/ou une troisième vanne (5), qui est agencée dans la conduite en dérivation (4), et à l'aide de laquelle il est possible de réguler le flux de gaz passant dans la conduite en dérivation (4), et/ou une quatrième vanne (10), qui est agencée directement devant l'entrée de l'élément chauffant (9), et à l'aide de laquelle il est possible de réguler le flux de gaz rentrant dans l'élément chauffant (9).

3. Dispositif de séchage selon l'une des revendications précédentes, comprenant une pompe (2), une soufflante (2) et/ou un ventilateur (2), à l'aide duquel du gaz peut être pompé ou refoulé dans le dispositif de séchage et/ou dans l'entrée de l'élément chauffant (9) et/ou dans l'entrée de l'adsorbeur (6) et/ou dans la conduite en dérivation (4).

4. Dispositif de séchage selon l'une des revendications précédentes, comprenant un filtre à poussières (3), qui, en se référant à la direction du flux de gaz, est agencé en amont de la pompe (2) et/ou de la soufflante (2) et/ou du ventilateur (2) et/ou en amont de l'élément chauffant (9) et/ou en amont de l'adsorbeur (6), et/ou comportant un filtre à poussières (14) à l'ouverture d'évacuation (12).

5. Dispositif de séchage selon l'une des revendications précédentes, dans lequel l'élément chauffant (9) est un collecteur thermique solaire et/ou un tube collecteur à vide et/ou un chauffage électrique.

6. Dispositif de séchage selon l'une des revendications précédentes, dans lequel l'adsorbeur (6) peut être échauffé au moyen d'un chauffage agencé sur l'adsorbeur et/ou par rayonnement solaire sur l'élément.

7. Dispositif de séchage selon l'une des revendications précédentes, dans lequel l'adsorbeur (6) renferme du gel de silice.

8. Module solaire comprenant un dispositif de séchage selon l'une des revendications précédentes.

9. Procédé de séchage d'un module solaire (1), d'après lequel au cours d'une étape, du gaz est envoyé, à une première température, à travers au moins un adsorbeur (6), par l'intermédiaire d'un raccord de branchement (8), dans le module solaire (1), et d'après lequel un gaz, notamment de l'air, au cours d'une autre étape, est tout d'abord échauffé à une deuxième température plus élevée que la première température, et est ensuite envoyé à travers l'adsorbeur (6) en vue de sécher celui-ci et/ou de le régénérer,
**caractérisé en ce que**
le gaz, au cours de ladite autre étape, est échauffé à la deuxième température dans un élément chauffant (9), qui est distinct de l'adsorbeur (6), et est évacué de l'adsorbeur (6) par l'intermédiaire d'une ouverture d'évacuation (12), qui est reliée, sur le plan de l'écoulement des gaz, par l'intermédiaire d'une première vanne (11), à la sortie de l'adsorbeur (6), au moyen d'un piquage de dérivation entre cette sortie et le raccord de branchement (8).

10. Procédé selon la revendication précédente, d'après lequel l'élément chauffant est un collecteur thermique solaire et/ou un tube collecteur à vide et/ou un chauffage électrique.

11. Procédé selon l'une des deux revendications précédentes, d'après lequel l'adsorbeur est échauffé au cours de ladite autre étape, notamment au moyen d'un chauffage électrique agencé sur l'adsorbeur, et/ou par l'action du rayonnement solaire sur l'adsorbeur.

12. Procédé selon l'une des revendications 9 à 11, d'après lequel, au cours de l'un et/ou de l'autre étape, du gaz est envoyé à travers des filtres à poussières avant et/ou après le passage à travers l'adsorbeur et/ou l'élément chauffant.

13. Procédé selon l'une des revendications 9 à 11, d'après lequel le procédé est mis en oeuvre à l'aide d'un dispositif de séchage selon l'une des revendications 1 à 7.
